(19) Europäisches Patentamt / European Patent Office / Office européen des brevets

(11) **EP 2 202 880 B1**

(12) **EUROPEAN PATENT SPECIFICATION**

(45) Date of publication and mention
of the grant of the patent:
**21.08.2013 Bulletin 2013/34**

(51) Int Cl.:
*H03F 3/68* (2006.01)　　*H03F 3/20* (2006.01)
*H04R 3/12* (2006.01)　　*H03F 1/52* (2006.01)
*H03F 3/187* (2006.01)　　*H05K 5/00* (2006.01)
*H03F 3/21* (2006.01)　　*H03F 1/02* (2006.01)
*H03F 3/72* (2006.01)

(21) Application number: **08841759.7**

(22) Date of filing: **08.10.2008**

(86) International application number:
**PCT/JP2008/068276**

(87) International publication number:
**WO 2009/054265 (30.04.2009 Gazette 2009/18)**

(54) **AUDIO POWER AMPLIFIER**

AUDIOLEISTUNGSVERSTÄRKER

AMPLIFICATEUR DE PUISSANCE AUDIO

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **23.10.2007 JP 2007274544**

(43) Date of publication of application:
**30.06.2010 Bulletin 2010/26**

(73) Proprietor: **Toa Corporation**
**Kobe-Shi, Hyogo 650-0046 (JP)**

(72) Inventor: **KAWAGUCHI, Koji**
**Kobe-shi**
**Hyogo 650-0046 (JP)**

(74) Representative: **Hedges, Martin Nicholas et al**
**A.A. Thornton & Co.**
**235 High Holborn**
**London WC1V 7LE (GB)**

(56) References cited:
**EP-A1- 0 080 771**　　**EP-A1- 1 853 086**
**WO-A1-2007/080879**　　**JP-A- 62 271 509**
**JP-U- 2 026 892**　　**JP-U- 03 088 018**
**JP-U- 60 047 316**

## Description

This invention relates to an audio power amplifier (hereinafter referred to simply as power amplifier) and, more particularly, to a high-impedance power amplifier.

An example of such power amplifier of this type is disclosed in JP09-070099. According to this art, an audio signal amplified in an amplifying circuit as amplifying means is supplied through an isolation transformer to a loudspeaker line. A plurality of loudspeakers are connected in parallel to the loudspeaker line. The disposition of the isolation transformer between the amplifying circuit and the loudspeaker line can secure the power amplifier including the amplifying circuit from accidents such as lightning strike. Each of the loudspeakers is a high-impedance loudspeaker having a matching transformer connected to its voice coil.

EP 185386, which is considered to represent the closest prior art, discloses a power amplifier having a plurality of amplifiers each receiving an audio signal, mode selecting means for selecting a desired one of first and second modes, in the first mode, separate audio signals being inputted through respective ones of the plurality of amplifying means and in the second mode, the same audio signal being inputted to said plurality of amplifying means, the output signals being combined to thereby form a combined audio signal, and the combined audio signal being externally outputted.

A power amplifier of the above-described type, one outputting an audio signal of 100 V in effective value from the secondary side of the isolation transformer when the amplifying circuit is providing its maximum output, is called a power amplifier of 100 V type, and one outputting an audio signal of 70 V in effective value is called a power amplifier of 70 V type. The isolation transformer for the 100 V type is so designed such that its maximum output voltage can be 100 V in effective value, and the isolation transformer for the 70 V type is so designed such that its maximum output voltage can be 70 V in effective value. Accordingly, as the maximum output of the amplifying circuit is larger, i.e. as the rated output of the power amplifier is larger, the rated output of the isolation transformer becomes larger. Then, the whole power amplifier including such isolation transformer undesirably becomes large in size and weight.

Prior techniques also have a problem that they could not adaptively cope with change of conditions in which power amplifiers are used. For example, when the number of loudspeakers to be used is increased, another power amplifier having a rated output larger than the currently used one must be used. When the number of loudspeakers is to be reduced, it is not necessary to use an additional power amplifier, but the performance of the currently used power amplifier is excessive and, therefore, is uneconomical. The same can be said when the number of loudspeaker lines or, in other words, the number of channels is changed.

An object of the present invention is to provide a power amplifier which is small in size and weight and can flexibly adapt itself to various use conditions.

According to a first aspect of the present invention, there is provided an audio power amplification method as defined in claim 1. The present invention further provides an audio power amplifier as defined in claim 2.

For the power amplifier of the present invention with the above-described arrangement, let it be assumed that the first mode, for example, is selected by the mode selecting means. In this case, separate audio signals are applied to the respective amplifying means. The respective amplifying means amplify the applied audio signals, and the amplified audio signals are applied to the primary sides of the corresponding transformers. The first voltage-transformed audio signals transformed to the first predetermined voltage are developed from the first portions of the respective transformers. The first transformed audio signals are separately outputted, and, are applied to separate loudspeaker lines, for example. In other words, in the first mode, a multi-channel power amplifier is provided, in which a plurality of audio signals are separately amplified and supplied to separate loudspeaker lines.

On the other hand, when the second mode is selected by the mode selecting means, the same audio signal is applied to the respective amplifying means. The respective amplifying means amplify the inputted audio signal, and the resulting amplified audio signals are applied to the primary sides of the corresponding transformers. Then, the second transformed audio signals voltage transformed to the second voltage lower than the first voltage are separately developed from the second portions of the secondary sides of the respective transformers. The second transformed audio signals are combined to thereby provide a combined audio signal of the same voltage as the first voltage. The combined audio signal is externally outputted and supplied to one loudspeaker line, for example. In other words, in the second mode, a single-channel power amplifier is provided, in which a single audio signal is amplified and supplied to a single loudspeaker line. Since the audio signal is amplified in parallel in a plurality of amplifying circuits, the power amplifier formed can provide large output composed of maximum outputs of these plural amplifier circuits, although the power amplifier is a single-channel power amplifier. Furthermore, since the transformation of the amplified audio signals as amplified in the respective amplifying circuits are shared by a plurality of transformers associated with the respective amplifying circuits, capacities matching the maximum outputs of the corresponding amplifying circuits are enough for the respective transformers. In other words, transformers having large capacities matching the rated output of the power amplifier as a whole need not be used.

The mode selecting means is provided with input-side switching means switchable between a first state for inputting separate audio signals to the respective amplifying means, and a second state for inputting the same audio signal to the respective amplifying means. In this case, the input-side switching means is placed in the first state for the first mode and in the second state for the second mode.

The mode selecting means is provided with output-side switching means switchable between a third state for serially connecting the second portions of the secondary sides of the respective transformers to thereby provide combining means for developing a combined audio signal, and a fourth state for breaking the said series connection so that the combining means is not formed. The output-side switching means is placed in the fourth state for the first mode and in the third state for the second mode.

Furthermore, the second portion of the secondary side of each transformer may be a part of the first portion of the secondary side. For example, an intermediate tap may be disposed at an intermediate location on the secondary side so that the second portion can be provided between one end of the secondary side and the intermediate tap, with the first portion provided between the opposed ends of the secondary side. Alternatively, two intermediate taps may be disposed at intermediate locations on the secondary side to provide the second portion between the two intermediate taps, with the first portion provided between the two ends of the secondary side. Alternatively, two windings having different numbers of conductor turns may be used as the secondary side, with the winding having a a larger number of conductor turns used as the first portion, and with the winding having a smaller number of conductor turns used as the second portion.

Preferably, the value of the second voltage is approximately equal to the value of the first voltage divided by the number of the amplifying means (or the transformers).

The amplifying means, the transformers and the mode switching means may be housed in the same casing. The casing referred to herein may be one which is mounted on a cabinet rack according to the known EIA (Electronic Industries Alliance) standards, for example.

In order that the invention may be well understood, there will now be described some embodiments thereof, given by way of example, reference being made to the accompanying drawings in which:

> FIGURE 1 is a block diagram showing a schematic arrangement according to one embodiment of the present invention.
> FIGURE 2 is an illustration for use in explaining effects of the embodiment.
> FIGURE 3 is an illustration showing the comparison with FIGURE 2.
> FIGURE 4 is a block diagram of another example according to the embodiment.

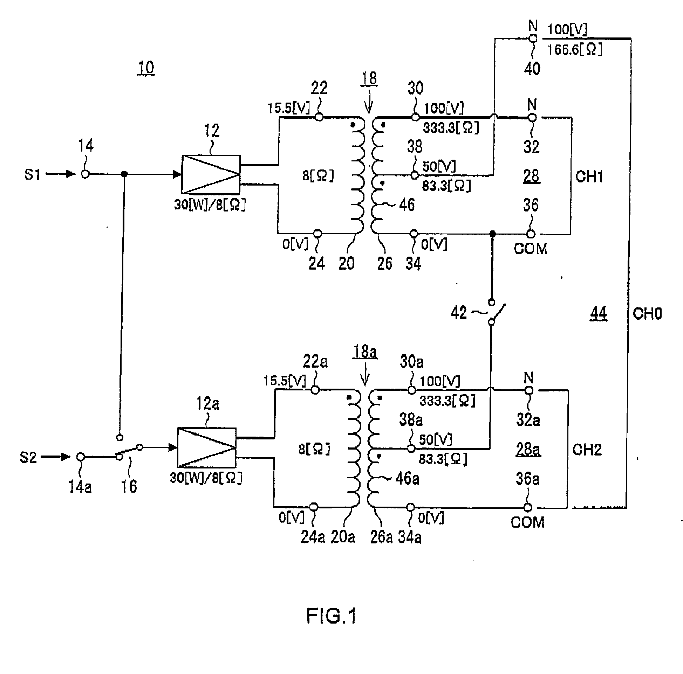

An embodiment of the present invention is described with reference to FIGURES 1 through 3.

As shown in FIGURE 1, a power amplifier 10 according to this embodiment includes a plurality of amplifying circuits, e.g. two amplifying circuits 12 and 12a. The amplifying circuits 12 and 12a are made according to the same specifications, and has a rated output of 30 W and an output impedance (load impedance) of 8 Ω, for example. The amplifying circuit 12 is for Channel 1 CH1 and has its input connected to an input terminal 14 for Channel 1 CH1. The other amplifying circuit 12 a is for Channel 2 CH2 and has its input connected through a c-contact type relay 16 serving as input switching means to either an input terminal 14a for Channel 2 CH2 or the input terminal 14 for Channel 1 CH1.

The relay 16 switches in response to the operation of a mode selecting switch (not shown). The mode selecting switch is to manually switch between a later-mentioned multi-channel mode or a first mode and a later-mentioned large-output mode or a second mode. For example, when the multi-channel mode is selected through the mode selecting switch, the relay 16 switches to connect the input of the amplifying circuit 12a to the input terminal 14a for Channel 2 CH2 as shown in FIGURE 1, whereas, when the large-output mode is selected, the relay 16 switches to connect the input of the amplifying circuit 12a to the input terminal 14 for Channel 1 CH1.

The output of the amplifying circuit 12 for Channel 1 CH1 is connected to terminals 22 and 24 of the primary winding 20 of an output transformer (hereinafter referred to simply as transformer) 18. One terminal 30 of the secondary winding 26 of the output transformer 18 is connected to a normal line terminal 32 constituting an output terminal 28, and the other terminal 34 is connected to a common line terminal 36 constituting the output terminal 28. An intermediate tap terminal 38 is provided right at the midpoint of the secondary winding 26 of the transformer 18 and is connected to a normal line terminal 40 for a later-mentioned Combined channel CH0.

For Channel 2 CH2 side, a transformer 18a according to the same specifications as those adopted for Channel 1 CH1 is used, and the output of the amplifying circuit 12a for Channel 2 CH2 is connected to terminals 22a and 24a of the primary winding 20a of the transformer 18a. One terminal 30a of the secondary winding 26a of the transformer 18a is connected to a normal line terminal 32a constituting an output terminal 28a, and the other terminal 34a is connected to a common line terminal 36a constituting the output terminal 28a. The common line terminal 36a, together with the above-described normal line terminal 40 for Combined channel CH0, constitutes an output terminal 44 for Combined channel CH0. An intermediate tap terminal 38a is connected or disconnected through an a-contact type (or b-contact type) relay 42, serving as output-side switching means, to and from the common line terminal 34 of the secondary winding 26 of the transformer 18 for Channel 1 CH1.

The relay 42 operates together with the input-side relay 16 in response to the operation of the above-described mode selecting switch. For example, when the multi-channel mode is selected by the mode selecting switch, the relay 42 is turned OFF (i.e. opened) as shown in FIGURE 1. This causes the common line terminal 34 for Channel 1 CH1 and the intermediate tap terminal 38a for Channel 2 CH2 to be disconnected from each other. In other words, the transformers 18 and 18a are isolated from each other. On the other hand, when the large-output mode is selected by the mode selecting switch, the relay 42 is turned ON (i.e. closed). This causes the common line terminal 34 for Channel 1 CH1 and the intermediate tap terminal 38a for Channel 2 CH2 to be interconnected. This, in turn, causes that portion 46 of the secondary winding 28 of the transformer 18 for Channel 1 CH1 which is between the intermediate tap terminal 38 and the common line terminal 34, and that portion 46a of the secondary winding 28 of the transformer 18a for Channel 2 CH2 which is between the intermediate tap terminal 38a and the common line terminal 34a, to be connected in series between the normal line terminal 40 and the common line terminal 36a, which constitute the output terminal 44 for Combined channel CH0.

The power amplifier 10 according to this embodiment as arranged above is used in the following manner.

Let it be assumed, for example, that the multi-channel mode is selected through the mode selecting switch. The input-side relay 16 switches to connect the input of the amplifying circuit 12a for Channel 2 CH2 to the input terminal 14a for Channel 2 CH2. At the same time, the output-side relay 42 is turned OFF. This causes Channel 1 CH1 and Channel 2 CH2 to be independent of each other.

In this condition, when an audio signal S1 is externally supplied to the input terminal 14 for Channel 1 CH1 from an audio signal generating apparatus (not shown), e.g. a microphone or a CD (Compact Disc) player, the audio signal S1 is inputted to the amplifying circuit 12 for Channel 1 CH1. The amplifying circuit 12 amplifies the input audio signal S1, and the amplified audio signal is applied to the primary winding 20 of the transformer 18, and a voltage appears between the terminals 22 and 24 of the primary winding 20. This voltage varies as the voltage of the audio signal S1 varies from 0 V to various values expressed in terms of effective value. In this case, let it be presumed that the voltage appearing between the terminals 22 and 24 does not change to a value larger than the effective value of 15.5 V. In other words, the output voltage of the transformer 18 is 15.5 V at its maximum in terms of effective value. This voltage value E of 15.5 V can be determined from the following Equation 1.

[Equation 1]

$$P = E^2/Z \qquad \therefore E = \{P \cdot Z\}^{1/2}$$

where P is the maximum output of the amplifying circuit 12, and Z is the output impedance of the amplifying circuit 12.

The application of the amplified audio signal to the primary winding 20 of the transformer 18 results in development of a transformed audio signal between the terminals 30 and 34 of the secondary winding 26 of the transformer 18. The transformed audio signal has a value of 100 V at its maximum, for example, in terms of effective value, if the power amplifier 10 of this embodiment is of 100 V type. The transformed audio signal having an effective value of 100 V at its maximum is externally outputted via the output terminal 28 (i.e. the terminals 32 and 36) for Channel 1 CH1. Thus, when a loudspeaker line (not shown) is connected to the output terminal 28, an audio signal having an effective value of 100 V is transmitted to respective loudspeakers (not shown) through the loudspeaker line. The output impedance of Channel 1 CH1 is 333.3 Ω according to the Equation 1.

When an audio signal S2, different from the one for Channel 1 CH1, is externally applied to the input terminal 14a for Channel 2 CH2, the audio signal S2 is inputted to the amplifying circuit 12a for Channel 2 CH2. The amplified audio signal as amplified in the amplifying circuit 12a is applied to the primary winding 20a of the transformer 18a, resulting in appearance of a voltage having a value 15.5 V at its maximum as expressed in terms of effective value between the terminals 22a and 24a of the primary winding 20a of the transformer 18a, as in the case of Channel 1 CH1, which, in turn, causes a transformed audio signal having an effective value of 100 V at its maximum to be developed between the terminals 30a and 34a of the secondary winding 26a. The voltage-transformed audio signal is externally outputted via the output terminal 28a (i.e. the terminals 32a and 36a) for Channel 2 CH2. Thus, by connecting a loudspeaker line (not shown), different from the one for Channel 1 CH1, to the output terminal 28a, an audio signal of 100 V at its maximum in terms of effective value is transmitted to respective loudspeakers (not shown) through the loudspeaker line. The output impedance for Channel 2 CH2 is also 333.3 Ω.

As described above, the power amplifier 10 according to this embodiment functions as a multi-channel (2-channel) amplifier with Channel 1 CH 1 having a rated output of 30 W and Channel 2 CH2 having a rated output of 30 W.

Next, let it be assumed that the large-output mode is selected through the above-described mode selecting switch. In this case, the input-side relay 16 switches to connect the input of the amplifying circuit 12a for Channel 2 CH2 to the input terminal 14 for Channel 1 CH1. At the same time, the output-side relay 42 is turned ON.

When the audio signal S1 is applied to the input terminal 14 for Channel 1 CH1 in this condition, the audio signal S1 is applied to both the amplifying circuit 12 for Channel 1 CH1 and the amplifying circuit 12a for Channel 2 CH2. The amplified audio signal as amplified in the amplifying circuit 12 for Channel 1 CH1 is applied to the primary winding 20 of the transformer 18, as in the case of the above-described multi-channel mode, resulting in appearance of a voltage having an effective value of 15.5 V at its maximum between the terminals 22 and 24 of the primary winding 20. Also, the amplified audio signal as amplified in the amplifying circuit 12a for Channel 2 CH2 is applied to the primary winding 20a of the transformer 18a, resulting in appearance of a voltage having an effective value of 15.5 V at its maximum between the terminals 22a and 24a of the primary winding 20a.

Considering the transformer 18 for Channel 1 CH1, a voltage-transformed audio signal having an effective value of 100 V at its maximum appears between the terminals 30 and 34 of the secondary winding 26 of the transformer 18, as described above. At the same time, a transformed audio signal having an effective value of one half of 100 V, i.e. 50 V, at its maximum appears between the intermediate tap terminal 38 and the common line terminal 34, which are at the two ends of the portion 46 of the secondary winding 26. The output impedance of the portion 46 across which this transformed audio signal appears is 83.3 $\Omega$ according to the above-described Equation 1.

In the transformer 18a for Channel 2 CH2, too, a voltage-transformed audio signal having an effective value of 100 V at its maximum appears between the terminals 30a and 34a of the secondary winding 26a of the transformer 18a. At the same time, a transformed audio signal having an effective value of 50 V at its maximum appears between the intermediate tap terminal 38a and the common line terminal 34a, which are at the two ends of the portion 46a of the secondary winding 26a. The output impedance of the portion 46a across which this transformed audio signal appears is also 83.3 $\Omega$ according to the above-described Equation 1.

The portion 46 for Channel 1 CH1 and the portion 46a for Channel 2 CH2 are connected in series between the normal line terminal 40 and the common line terminal 36a, which form the output terminal 44 for Combined channel CH0. The transformed audio signals having an effective value of 50 V at their maximum developed in the portions 46 and 46a are in phase with each other. This is similar to the series connection of batteries of 50 V. Accordingly, an audio signal having an effective value of 100 V at its maximum, resulting from combination of these audio signals of 50 V at the maximum, is externally outputted through the output terminal 44 (i.e. 40 and 36a) for Combined channel CH0. Then, the audio signal having an effective value of 100 V at its maximum is constant-voltage transmitted to the respective loudspeakers (not shown) through the loudspeaker line (not shown) connected to the output terminal 44 for Combine channel CH0.

The output impedance of Combined channel CH0 is 166.6 $\Omega$, which is the sum of the output impedances of the portions 46 and 46a, each being 83.3 Q.

The audio signal outputted through Combined channel CH0 is the result of amplification in parallel in the two amplifying circuits 12 and 12a, and, therefore, the rated output of the Combined channel CH0 is 60 W, which results from combining the maximum outputs of the two amplifying circuits 12 and 12a.

As described above, the power amplifier 10 of this embodiment in the large-output mode functions as a large output amplifier with Combined channel CH0 having a large rated output of 60 W. In this large-output mode, however, Channel 1 CH1 and Channel 2 CH2 are disabled. In other words, only one channel, which is Combined channel CH0, is available.

In addition, in the large-output mode, while a large rated output of 60 W is available, each of the transformers 18 and 18a need only have capacity enough for the maximum output of 30 W of the corresponding amplifying circuit 12 or 12a. In other words, a transformer having capacity for the rated output of 60 W of the power amplifier as a whole is not required. Thus, in comparison with realizing a power amplifier having a rated output of 60 W, using the above-quoted background technique, the present embodiment of the invention can reduce the size and weight of the power amplifier 10 including the transformers 18 and 18a. This feature is very advantageous when the power amplifier 10 is to be mounted to a cabinet rack conforming to the EIA standards.

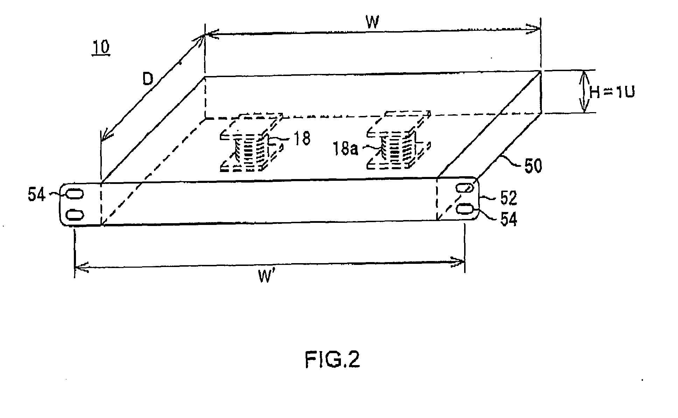

More specifically, as shown in FIGURE 2, the width dimension W of a casing 50 to be mounted to such cabinet rack, or more particularly, the dimension W' (= 465 mm) between mounting screw holes 54 at opposite ends of a front panel 52, is prescribed. With respect to the depth dimension D, its allowable range is also prescribed. It is also prescribed that the height H should be a multiple of a standard size unit U (= 44.5 mm). Considering the fact that the rated output of each of the transformers 18 and 18a of the present embodiment is 30 W, it is fully possible to dispose the transformers 18 and 18a in a plane within the casing 50 as shown in FIGURE 2. Although not shown, it is also possible to mount other components including the amplifying circuits 12 and 12a and the relays 16 and 42, within the casing 50. Also, by adopting an appropriate design, the height of each of the transformers 18 and 18a can be smaller than the standard size unit U. In other words, the height H of the casing 50 can be made minimum, i.e. H = 1 x U.

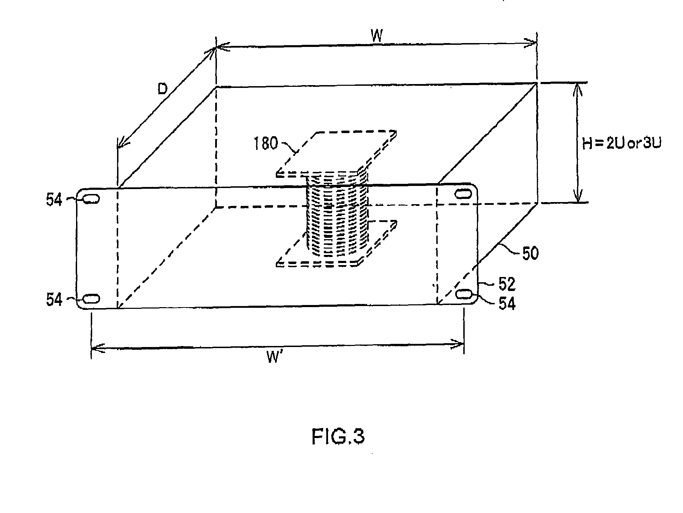

On the other hand, a conventional art requires a transformer 180 having a rated capacity of 60 W. Due to the restrictions on the size, in particular, the height, of the transformer 180, the height H of the casing 50 is, as shown in FIGURE 3, H = 2 x U, or, in some cases, H = 3 x U, for example. The height H is two or three times as large as that of the present embodiment. Due to such increased height H, there are some useless portions in the interior space of the casing 50. This proves that the power amplifier 10 according to the present embodiment is advantageous in mounting it on the cabinet rack.

As described above, the power amplifier 10 according to this embodiment functions as a multi-channel amplifier when in the multi-channel mode, and functions as a large output amplifier, although it is a single-channel amplifier, in the large-output mode. Thus, the power amplifier 10 can solely function to flexibly meet various use conditions including an application requiring multiple channels and an application requiring a large output. In addition, it is small in size and light in weight in comparison with ones according to conventional art, so that it is particularly suitable for mounting on a cabinet rack.

The amplifying circuit 12 and the transformer 18 for Channel 1 CH1 and the amplifying circuit 12a and the transformer 18a for Channel 2 CH2 comply with the same specifications, respectively. Accordingly, from the viewpoint of the manufacturers of the power amplifier 10 according to the present embodiment, ease of designing and managing the stock of the various components including the amplifiers 12 and 12a and the transformers 18 and 18a and possibility of mass-production etc. can be expected, so that lowering of the cost of the power amplifiers 10 can be realized. In the most extreme case, by manufacturing the mode selecting switch operable only by the manufacturers, one model of power amplifiers 10 can be shipped either as multi-channel amplifiers or as large output amplifiers.

In the large-output mode, the outputs of the amplifying circuits 12 and 12a are combined, but, since the outputs of the amplifying circuits 12 and 12a are not directly connected each other, the amplifying circuits 12 and 12a need not be balanced relative to each other. Accordingly, in comparison with BTL (Balanced Transformer Less) connection known as a technique for increasing an output of a low-impedance power amplifier, for example, the present invention can make it possible to increase the output of a power amplifier in a very safe and easy manner. In the BTL connection, the circuit arrangement is complicated because of the need for keeping balance among the amplifying circuits, and, if the balance is lost, the power amplifier including the amplifying circuits may be broken.

If one of the amplifying circuits 12 and 12a fails, the output of the power amplifier 10 as a whole decreases, but an audio signal is continuously outputted from the power amplifier 10 (i.e. from the output terminal 44 of Combined channel CHO) since the outputs of the amplifying circuits 12 and 12a are not directly connected to each other, as stated above. This fact is very advantageous for PA (Public Address) systems, in particular, emergency address systems, which are used to give audio information to a number of listeners, for example.

Generally, emergency address systems use a battery providing a DC voltage of 24 V as an emergency power supply. The power amplifier 10 according to the present embodiment can properly operate by applying only such 24 V DC voltage thereto. In other words, there is no need to boost the DC voltage of 24 V or to convert it to a commercial AC voltage. As is understood from FIGURE 1, the power amplifier 10 according to this embodiment can properly operate in either of the multi-channel mode and the large-output mode only if a voltage of 15.5 V (< 24 V) is developed in the primary windings 20 and 20a of the transformers 18 and 18a. On the other hand, according to conventional techniques, it is necessary to boost the DC voltage from a battery or to convert it to a commercial AC voltage, for a large output power amplifier, in particular.

In the embodiment, the amplifying circuits 12 and 12a have been described to have a rated output of 30 W and an output impedance of 8 $\Omega$, but they are not limited to such circuits. Also, the amplifying circuits 12 and 12a may have different rated outputs and output impedances.

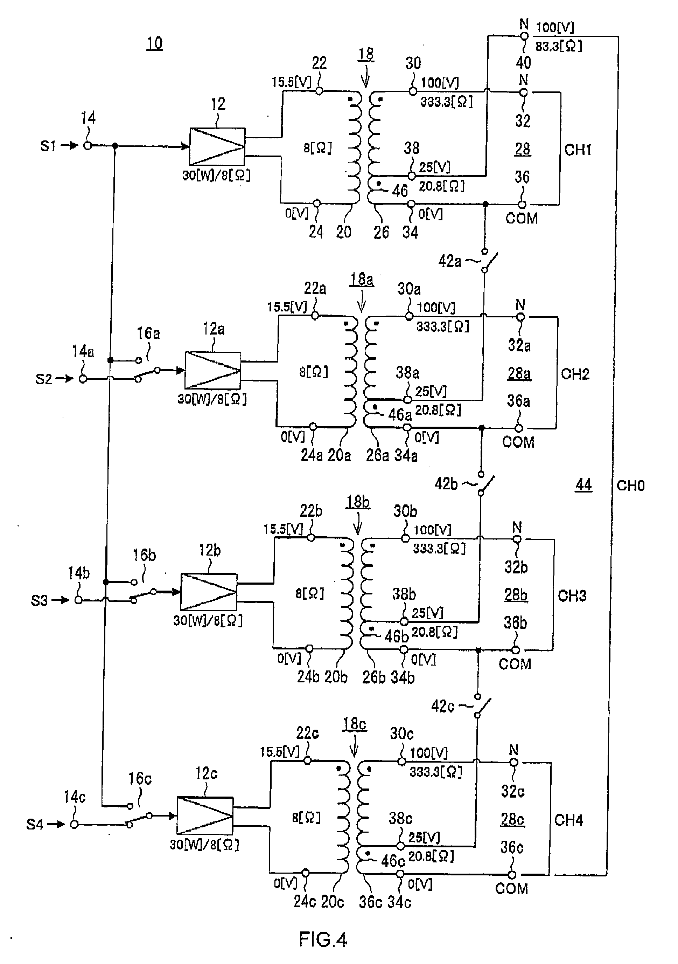

The number of channels in the multi-channel mode according to the described embodiment is two, namely, Channel 1 CH1 and Channel 2 CH2, but it is not limited to two. For example, as shown in FIGURE 4, there may be four channels, namely, Channel 1 CH1 through Channel 4 CH4. In FIGURE 4, the components constituting respective ones of Channel 3 CH3 and Channel 4 CH4 are the same as those constituting Channel 1 CH1. Therefore, the components of Channel 3 CH3 corresponding to the ones of Channel 1 CH1 are given the same reference numerals with "b" attached to the respective ends of the reference numerals, the components of Channel 4 CH4 corresponding to the ones of Channel 1 CH1 are given the same reference numerals with "c" attached to the respective ends of the reference numerals, and their detailed explanations are not given. Further, Channel 3 CH3 and Channel 4 CH4 are provided with input-side relays 16b and 16c and output-side relays 42b and 42c, respectively.

It should be noted, however, that, in the arrangement shown in FIGURE 4, the intermediate tap terminals 38, 38a, 38b and 38c on the secondary windings 26, 26a, 26b and 26c of the respective transformers 18, 18a, 18b and 18c are disposed at such locations that voltages of 25 V at the maximum can be developed between the respective intermediate tap terminals and the corresponding common line terminals 34, 34a, 34b and 34c. This voltage value of 25 V at the maximum is equal to the maximum effective voltage value (= 100 V) of the audio signal supplied to the loudspeaker line divided by the number (= 4) of the amplifying circuits 12, 12a, 12b and 12c (or the transformers 18, 18a, 18b and 18c). In other words, it is so arranged that the sum of the voltages having a value of 25 V at the maximum relating to the respective transformers 18, 18a, 18b and 18c can be equivalent to the maximum voltage expressed in effective value of the audio signal supplied to the loudspeaker line (= 100 V). The common line terminal 36c for Channel CH3 is use in common with Combined channel CH0. The output impedance of each of the portions 46, 46a, 46b and 46c of the respective transformers 18, 18a, 18b and 18c, in which the voltage-transformed audio signal of 25 V at the maximum is developed, is 20.8 $\Omega$ according to Equation 1. The output impedance of Combined channel CH0 is 83.3 Ω.

In the multi-channel mode, the power amplifier 10 arranged as shown in FIGURE 4 functions as a multi-channel power amplifier having four channels, namely, Channel 1 CH1 through Channel 4 CH4. In the large-output mode, the power amplifier 10 of FIGURE 4 functions as a large output amplifier having a rated output as large as 120 W although it has only a single channel of Combined channel CH0. In addition, since this power amplifier 10 does not need a large transformer corresponding to the rated output of 120 W, the reduction of size and weight of the power amplifier 10 is more remarkable.

The present embodiment has been described by means of the 100 V type power amplifier 10, but it is needless to say that the present invention can be embodied in 70 V type power amplifiers. Also, the present invention can be embodied in 3-line loudspeaker line power amplifiers having an emergency line in addition to normal and common lines.

Further, in place of the relays 16 and 42, manual switches or, in an extreme case, jumper lines may be used. The same thing can be said with respect to the relays 16, 16a, 16b, 16c, 42, 42a, 42b and 42c of the arrangement shown in FIGURE 4.

Although one intermediate tap terminal 38, 38a is disposed on each of the secondary windings 26 and 26a of the transformers 18 and 18a, two intermediate tap terminals, for example, may be provided on each of the secondary windings 26 and 26a. In the large-output mode, the two portions respectively defined by the two pairs of intermediate tap terminals are connected in series between the Combined channel CH0 output terminals 40 and 36a. Alternatively, another secondary winding having a smaller number of conductor turns may be provided for each of the transformers 18 and 18a, and, in the large-output mode, the two secondary windings having fewer conductor turns are connected in series between the Combined channel CH0 output terminals 40 and 36a.

In the multi-channel mode, it is desirable to keep open the normal line terminal 40 for Combined channel CH0 in order to improve the safety. To realize it in the arrangement shown in FIGURE 1, for example, an a-contact type (or b-contact type) relay similar to the output-side relay 42 is connected between the intermediate tap terminal 38 of the transformer 18 for Channel 1 CH1 and the normal line terminal 40, and is operated in conjunction with the output-side relay 42. Also, in the large-output mode, it is desirable to keep open the output terminal 28 (i.e. the terminals 32 and 36) for Channel 1 CH1 and the normal line terminal 32a for Channel 2 CH2. The same things can be applied to the arrangement shown in FIGURE 4.

## Claims

1. An audio power amplification method comprising:

   a first mode in which:

   separate audio signals are applied to respective ones of a plurality of amplifying means (12, 12a), first amplified audio signals outputted from said plurality of amplifying means that amplify said audio signals are inputted to primary sides of respective ones of a plurality of transformers (18, 18a) provided in association with respective ones of said amplifying means, respective ones of first portions (30, 34; 30a, 34a) of secondary sides of respective ones of said plurality of transformers transform respective ones of said first amplified audio signals to provide a plurality of first transformed audio signals of a first voltage (100V) higher than the voltage (15.5V) of said first amplified audio signals, and said plurality of first transformed audio signals separately outputted from respective ones of said first portions are outputted to respective ones of a plurality of loudspeaker lines; and

   a second mode in which:

   a same audio signal is applied to said plurality of amplifying means, second amplified audio signals amplified by and outputted from said plurality of amplifying means are inputted to the primary sides of associated ones of said plurality of transformers (18, 18a), respective ones of second portions (38, 34; 38a, 34a) of secondary sides of said respective ones of said plurality of transformers transform respective ones of said second amplified audio signals to provide a plurality of second transformed audio signals of second voltages (50V) lower than said first voltage, said plurality of second transformed audio signals separately outputted from respective ones of said second portions are serially combined to provide a composite audio signal, respective ones of said second voltages being such that the voltage resulting from serially combining said second voltages has a value equal to that of said first voltage, and said composite audio signal is outputted to a single loudspeaker line.

2. An audio power amplifier comprising:

   a plurality of amplifying means (12, 12a)

a plurality of transformers (18, 18a) provided in association with respective ones of said plurality of amplifying means, as amplified by the corresponding amplifying means; and
mode selecting means (16, 42) for selecting desired one of first and second modes;
wherein:

a secondary side (26, 26a) of each of said plurality of transformers has a first portion (30, 34; 30a, 34a) for transforming the voltage (15.5V) of said amplified audio signal to a first voltage (100V) higher than the voltage of said amplified audio signal and a second portion (38, 34: 38a, 34a) for transforming the voltage of said amplified audio signal to a second voltage (50V) lower than said first voltage, said second voltage being such that the serially combined value of said second voltages from said plurality of transformers is equal to said first voltage;

said mode selecting means comprises:

input side switching means switchable between a first state in which separate ones of said audio signals are inputted to respective ones of said plurality of amplifying means, and a second state in which same one of said audio signals is inputted to all of said plurality of amplifying means; and
output side switching means switchable between a third state in which said second portions of said secondary sides of said plurality of transformers are connected in series with each other to develop a combined audio signal, and a fourth state in which the serial connection of said second portions is cancelled;
said input side switching means assumes said first state in said first mode and assumes said second state in said second mode, and said output side switching means assumes said fourth state in said first mode and assumes said third state in said second mode.

3. An audio power amplifier according to Claim 2, wherein said second portion (38, 34; 38a, 34a) of each of said secondary sides (26, 26a) is part of said first portion (30, 34, 30a, 34a).

4. An audio power amplifier according to any one of Claims 2 and 3, wherein the value of said second voltage is equal to the value of said first voltage divided by the number of said amplifying means.

5. An audio power amplifier according to any one of Claims 2 through 4, wherein said plurality of amplifying means (12, 12a), said plurality of transformers (18, 18a), and said mode selecting means (16, 42) are housed in the same casing.

**Patentansprüche**

1. Verfahren zur Audioleistungsverstärkung, das Folgendes beinhaltet:

einen ersten Modus, in dem:

separate Audiosignale an jeweilige von mehreren Verstärkungsmitteln (12, 12a) angelegt werden, von den genannten mehreren, die genannten Audiosignale verstärkenden Verstärkungsmitteln ausgegebene erste verstärkte Audiosignale auf primären Seiten von jeweiligen von mehreren Transformatoren (18, 18a) eingegeben werden, die in Assoziation mit jeweiligen der genannten Vestärkungsmittel bereitgestellt werden, jeweilige von ersten Teilen (30, 34; 30a, 34a) von sekundären Seiten von jeweiligen der genannten mehreren Transformatoren jeweilige der genannten ersten verstärkten Audiosignale transformieren, um mehrere von ersten transformierten Audiosignalen einer ersten Spannung (100V) bereitzustellen, die höher ist als die Spannung (15,5 V) der genannten ersten verstärkten Audiosignale, und die genannten mehreren ersten separat von jeweiligen der genannten ersten Teile ausgegebenen transformierten Audiosignale zu jeweiligen von mehreren Lautsprecherleitungen ausgegeben werden; und

einen zweiten Modus, in dem:

ein selbes Audiosignal an die genannten mehreren Verstärkungsmittel angelegt wird, die von den genannten mehreren Verstärkungsmitteln verstärkten und ausgegebenen zweiten verstärkten Audiosignale auf den primären Seiten von assoziierten der genannten mehreren Transformatoren (18, 18a) eingegeben werden, jeweilige der genannten zweiten Teile (38, 34; 38a, 34a) von sekundären Seiten der genannten jeweiligen der genannten mehreren Transformatoren jeweilige der genannten zweiten verstärkten Audiosignale transformieren, um mehrere zweite transformierte Audiosignale mit zweiten Spannungen (50 V) bereitzustellen, die niedriger sind als die genannte erste Spannung, die genannten mehreren separat von jeweiligen der genannten zweiten Teile ausgegebenen zweiten transformierten Audiosignale seriell kombiniert werden, um ein zusammengesetztes Audiosignal bereitzustellen, wobei jeweilige der genannten zweiten Spannungen derart sind, dass die vom seriellen Kombinieren der genannten zweiten Spannungen resultierende Spannung einen Wert hat, der gleich dem der genannten ersten Spannung ist, und das genannte zusammengesetzte Audiosignal an eine einzelne Lautsprecherleitung ausgegeben wird.

2.  Audioleistungsverstärker, der Folgendes umfasst:

mehrere Verstärkungsmittel (12, 12a), mehrere Transformatoren (18, 18a), die in Assoziation mit jeweiligen der genannten mehreren Verstärkungsmittel bereitgestellt werden, verstärkt durch die entsprechenden Verstärkungsmittel; und Modusauswahlmittel (16, 42) zum Auswählen eines gewünschten Modus aus erstem und zweitem Modus; wobei:

eine sekundäre Seite (26, 26a) jedes der genannten mehreren Transformatoren einen ersten Teil (30, 34; 30a, 34a) zum Transformieren der Spannung (15,5 V) des genannten verstärkten Audiosignals in eine erste Spannung (100 V) hat, die höher ist als die Spannung des genannten verstärkten Audiosignals, und einen zweiten Teil (38, 34; 38a, 34a) zum Transformieren der Spannung des genannten verstärkten Audiosignals in eine zweite Spannung (50 V) hat, die niedriger ist als die genannte erste Spannung, wobei die genannte zweite Spannung derart ist, dass der seriell kombinierte Wert der genannten zweiten Spannungen von den genannten mehreren Transformatoren gleich der genannten ersten Spannung ist;

wobei das genannte Modusauswahlmittel Folgendes umfasst:

eingangsseitige Schaltmittel, die zwischen einem ersten Zustand, in dem separate der genannten Audiosignale in jeweilige der genannten mehreren Verstärkungsmittel eingegeben werden, und einem zweiten Zustand umgeschaltet werden können, in dem dasselbe eine der genannten Audiosignale in alle der genannten mehreren Verstärkungsmittel eingegeben wird; und ausgangsseitige Schaltmittel, die zwischen einem dritten Zustand, in dem die genannten zweiten Teile der genannten sekundären Seiten der genannten mehreren Transformatoren in Serie miteinander geschaltet sind, um ein kombiniertes Audiosignal zu entwickeln, und einem vierten Zustand geschaltet werden können, in dem die Serienschaltung der genannten zweiten Teile aufgehoben wird; die genannten eingangsseitigen Schaltmittel den genannten ersten Zustand in dem genannten ersten Modus annehmen und den genannten zweiten Zustand in dem genannten zweiten Modus annehmen, und die genannten ausgangsseitigen Schaltmittel den genannten vierten Zustand in dem genannten ersten Modus und den genannten dritten Zustand in dem genannten zweiten Modus annehmen.

3.  Audioleistungsverstärker nach Anspruch 2, wobei der genannte zweite Teil (38, 34; 38a, 34a) jeder der genannten sekundären Seiten (26, 26a) Teil des genannten ersten Teils (30, 34, 30a, 34a) ist.

4.  Audioleistungsverstärker nach einem der Ansprüche 2 und 3, wobei der Wert der genannten zweiten Spannung gleich dem Wert der genannten ersten Spannung dividiert durch die Anzahl der genannten Verstärkungsmittel ist.

5.  Audioleistungsverstärker nach einem der Ansprüche 2 bis 4, wobei die genannten mehreren Verstärkungsmittel (12, 12a), die genannten mehreren Transformatoren (18, 18a) und die genannten Modusauswahlmittel (16, 42) im selben Gehäuse untergebracht sind.

**Revendications**

1.  Procédé d'amplification de puissance audio, comprenant :

un premier mode, dans lequel :

des signaux audio séparés sont appliqués à des moyens amplificateurs respectifs parmi une pluralité de moyens amplificateurs (12, 12a), des premiers signaux audio amplifiés délivrés à partir de ladite pluralité de moyens amplificateurs qui amplifient lesdits signaux audio étant injectés aux côtés primaires de transformateurs respectifs parmi une pluralité de transformateurs (18, 18a) prévus en association avec des moyens amplificateurs respectifs parmi lesdits moyens amplificateurs, des portions respectives parmi des premières portions (30, 34 ; 30a, 34a) de côtés secondaires de transformateurs respectifs parmi ladite pluralité de transformateurs assurant la transformation de signaux audio amplifiés respectifs parmi lesdits premiers signaux audio amplifiés afin de procurer une pluralité de premiers signaux audio transformés ayant une première tension (100 V) laquelle est plus élevée que la tension (15,5 V) desdits premiers signaux audio amplifiés, et ladite pluralité de premiers signaux audio transformés, délivrée séparément à partir de premières portions respectives parmi lesdites premières portions, étant délivrée aux lignes de haut-parleur respectives parmi une pluralité de lignes de haut-parleur ; et

un second mode dans lequel :

un même signal audio est appliqué à ladite pluralité de moyens amplificateurs, alors que des seconds signaux audio amplifiés, ayant été amplifiés et délivrés par ladite pluralité de moyens amplificateurs, sont injectés aux côtés primaires de transformateurs associés parmi ladite pluralité de transformateurs (18, 18a), des portions respectives parmi des secondes portions (38, 34 ; 38a, 34a) de côtés secondaires desdits transformateurs respectifs parmi ladite pluralité de transformateurs assurant la transformation de seconds signaux audio amplifiés respectifs parmi lesdits seconds signaux audio amplifiés, afin de procurer une pluralité de seconds signaux audio transformés ayant des secondes tensions (50 V) lesquelles sont plus faibles que ladite première tension, ladite pluralité de seconds signaux audio transformés, délivrée séparément à partir de secondes portions respectives parmi lesdites secondes portions, étant combinée en série afin de procurer un signal audio composite, des tensions respectives parmi lesdites secondes tensions étant telles que la tension, résultant de l'opération de combinaison en série desdites secondes tensions, possède une valeur qui est égale à celle de ladite première tension, et ledit signal audio composite est délivré à une seule ligne de haut-parleur.

2. Amplificateur de puissance audio, comprenant :

une pluralité de moyens amplificateurs (12, 12a) ;

une pluralité de transformateurs (18, 18a) prévue en association avec des moyens amplificateurs respectifs parmi ladite pluralité de moyens amplificateurs, telle qu'elle est amplifiée par les moyens amplificateurs correspondants ; et des moyens de sélection de mode (16, 42) destinés à sélectionner un mode souhaité parmi les suivants, à savoir le premier mode et le second mode ;

cas dans lequel :

un côté secondaire (26, 26a) de chaque transformateur parmi ladite pluralité de transformateurs possède une première portion (30, 34 ; 30a, 34a) pour transformer la tension (15,5 V) dudit signal audio amplifié en une première tension (100 V) laquelle est plus élevée que la tension dudit signal audio amplifié, et une seconde portion (38, 34 ; 38a, 34a) pour transformer la tension dudit signal audio amplifié en une seconde tension (50 V) laquelle est plus faible que ladite première tension, ladite seconde tension étant telle que la valeur combinée en série desdites secondes tensions, émanant de ladite pluralité de transformateurs, est égale à ladite première tension ;

lesdits moyens de sélection de mode comprenant :

des moyens de commutation de côté entrée, aptes à être commutés entre un premier état dans lequel des signaux audio séparés parmi lesdits signaux audio sont injectés à des moyens amplificateurs respectifs parmi ladite pluralité de moyens amplificateurs, et un deuxième état dans lequel le même signal audio parmi lesdits signaux audio est injecté à tous les moyens amplificateurs parmi ladite pluralité de moyens amplificateurs ; et des moyens de commutation de côté sortie, aptes à être commutés entre un troisième état dans lequel lesdites secondes portions, desdits côtés secondaires de ladite pluralité de transformateurs, sont connectées en série l'une à l'autre afin de développer un signal audio combiné, et un quatrième état dans lequel la connexion série desdites secondes portions est annulée ; lesdits moyens de commutation du côté entrée adoptant ledit premier état dans ledit premier mode et adoptant ledit deuxième état dans ledit second mode, et lesdits moyens de commutation du côté sortie adoptant ledit quatrième état dans ledit premier mode et adoptant ledit troisième état dans ledit second mode.

3. Amplificateur de puissance audio selon la revendication 2, ladite seconde portion (38, 34 ; 38a, 34a) de chacun desdits côtés secondaires (26, 26a) faisant partie de ladite première portion (30, 34, 30a, 34a).

4. Amplificateur de puissance audio selon l'une quelconque des revendications 2 et 3, la valeur de ladite seconde tension étant égale à la valeur de ladite première tension divisée par le nombre desdits moyens d'amplification,

5. Amplificateur de puissance audio selon l'une quelconque des revendications 2 à 4, ladite pluralité de moyens amplificateurs (12, 12a), ladite pluralité de transformateurs (18, 18a), et lesdits moyens de sélection de mode (16, 42) étant abrités dans le même logement.

FIG.1

FIG.2

FIG.3

FIG.4

**EP 2 202 880 B1**

**REFERENCES CITED IN THE DESCRIPTION**

**Patent documents cited in the description**

- JP 9070099 A
- EP 185386 A